# EUROPEAN PATENT APPLICATION

(11) **EP 4 791 135 A1**
(43) Date of publication of application: **12.08.2026**
(21) Application number: 26156253.2
(22) Date of filing: 04.02.2026
(51) Int. Cl.: H05K 7/20

(54) **MODULAR DATA CENTER INFRASTRUCTURE**

(30) Priority: 06.02.2025 US 202563754967 P; 13.01.2026 US 202619446937
(71) Applicant: Vertiv Corporation, Westerville, OH 43082 (US)
(72) Inventor: PACAK, Matija, Westerville, 43082 (US); PAJIC, Marin, Westerville, 43082 (US)
(74) Representative: Ambroz, Simon

(57) **Abstract**

A modular data center infrastructure system can include one or more through modules and one or more end modules. The modules can be disposed above one or more cabinets, such as computer equipment cabinets. The modules can be disposed above an aisle between two rows of cabinets and/or coupled to opposing pairs of cabinets. The modules can be coupled to one another. The system can include a first through module coupled above a first opposing pair of the cabinets, a second through module coupled to the first through module and/or above a second opposing pair of the cabinets, and an end module coupled to one of the through modules and/or above a third opposing pair of the cabinets.

## Description

### CROSS-REFERENCE TO RELATED APPLICATION(S)

This application claims the benefit of U.S. Provisional Patent Application No. 63/754,967 filed February 6, 2025, and U.S. Nonprovisional Patent Application 19/446,937 filed January 13, 2026.

### TECHNICAL FIELD

The present disclosure relates generally to data centers and more specifically relates to infrastructure for data centers.

### BACKGROUND

Data centers are often different from one another, physically, but have similar infrastructure needs. For example, one data center may be much larger than another, but they both need electrical power, communications, and cooling equipment. Additionally, two data centers may have similar sizes, overall, but different layouts. For example, one data center may have a rectangular layout, relatively long and narrow, whereas another data center may have a more squared layout. These, and other, differences often require infrastructure to be uniquely designed for each data center, leading to significant installation complexity, long lead times, and higher overall installation costs.

### SUMMARY

Applicant has created new and useful devices, systems and methods for data center infrastructure. In at least one example, a modular data center infrastructure system according to the disclosure can quickly and easily be scaled to meet the needs of a variety of data centers. In at least one example, modules of the present disclosure can be pre-fabricated and arranged for simple on-site assembly (e.g., via hand tools) within an aisle of a data center, reducing or eliminating the need for on-site welding. In at least one example, the modular integration of direct liquid cooling helps ensure that high-performance computing needs are met seamlessly, boosting energy efficiency and overall performance. In at least one example, the modularity of the present system can promote quicker adoption cycles, reduced installation time, improved operational efficiency, and/or comprehensive, reliable performance.

In at least one example, a modular data center infrastructure system according to the disclosure can provide balanced cooling flow through a plurality of heat loads, such as by incorporating Tichelmann distribution, without on-site pipe balancing. In at least one example, a modular data center infrastructure system according to the disclosure can provide an integrated, plug-and-play solution that combines mechanical infrastructure, advanced secondary liquid cooling, cabling, leak containment, leak detection, internal lighting, power and/or communications, or any combination thereof. In at least one example, a modular data center infrastructure system according to the disclosure can provide faster deployment, reduced installation complexity, and enhanced operational performance, resulting in improved resource allocation, higher uptime, and overall operational excellence.

In at least one example, a modular data center infrastructure system according to the disclosure can include one or more through modules and one or more end modules. In at least one example, any or all of the modules can be disposed above one or more cabinets, such as computer equipment cabinets. In at least one example, any or all of the modules can be disposed above an aisle between two rows of cabinets, and/or coupled to opposing pairs of the cabinets. In at least one example, any or all of the modules can be coupled to one another. For example, the system can include a first through module coupled above a first opposing pair of the cabinets, a second through module coupled to the first through module and/or above a second opposing pair of the cabinets, an end module coupled to one of the through modules and/or above a third opposing pair of the cabinets, or any combination thereof. In at least one example, the first through module can be coupled between the end module and the second through module.

In at least one example, any or all of the modules can be as wide as the cabinets to which they are coupled. In at least one example, the first through module can have a first width of the first opposing pair of the cabinets. In at least one example, the second through module can have a second width of the second opposing pair of the cabinets. In at least one example, the end module can have a third width of the third opposing pair of the cabinets. The first width, the second width, the third width, or any combination thereof can be the same or different.

In at least one example, any or all of the modules can be as long, or longer, as the aisle is wide and/or can span the aisle. In at least one example, each of the modules can be as long than the aisle is wide. In at least one example, each of the modules can be longer than the aisle is wide. In at least one example, any of the modules can be shorter than the aisle is wide and/or be supported by other modules.

In at least one example, each through module can include a first tube for receiving cooling fluid flow in a first direction, a second tube for receiving cooling fluid flow in a second direction, a third tube for receiving cooling fluid flow in the first direction, or any combination thereof. In at least one example, the second direction can be opposite the first direction. In at least one example, the first direction and/or the second direction can be aligned with the aisle and/or the row(s) of cabinets. In at least one example, the end module, or the system generally, can include a reversing coupler for coupling the first tube of the first through module with the second tube of the first through module. In at least one example, the reversing coupler can redirect cooling fluid in the first tube, flowing in the first direction, to the second tube, flowing in the second direction and/or vice versa. In at least one example, the end module, or the system generally, can include a cap for capping, or plugging, the third tube of the first through module. In at least one example, any of the through modules, or the system generally, can include another cap for capping, or plugging, the first tube of that through module.

In at least one example, any or all of the through modules, or the system generally, can include one or more straight couplers to couple adjacent ones of the tubes. In at least one example, the system can include a first straight coupler for coupling the first tube of the first through module with the first tube of the second through module, a second straight coupler for coupling the second tube of the first through module with the second tube of the second through module, a third straight coupler for coupling the third tube of the first through module with the third tube of the second through module, or any combination thereof.

In at least one example, the system can include one or more cooling fluid distribution units for inducing cooling fluid flow through the tubes. In at least one example, the system can include a cooling fluid distribution unit for inducing cold cooling fluid to flow into the third tubes, such as flowing in the first direction, and/or receiving warm cooling fluid from the second tubes, such as flowing in the second direction. In at least one example, any or all of the through modules can include a first tap coupled to its third tube for directing the cold cooling fluid from its third tube to a first one of the cabinets and/or a second tap coupled to its first tube for receiving warm cooling fluid from the first one of the cabinets into its first tube. In at least one example, the first tap can direct the cold cooling fluid to one cabinet and/or the second tap can receive warm cooling fluid from another one of the cabinets.

In at least one example, the cooling fluid flow can be reversed. In at least one example, the cooling fluid distribution unit can induce the cold cooling fluid to flow into the second tubes, flowing in the second direction, and/or receive the warm cooling fluid from the third tubes, flowing in the first direction. In at least one example, any or all of the through modules can include a first tap coupled to its first tube and configured to direct the cold cooling fluid from its first tube to a first one of the cabinets and/or a second tap coupled to its third tube and configured to receive warm cooling fluid from the first (or another) one of the cabinets into its third tube.

In at least one example, any or all of the modules can include one or more drip trays disposed below the tubes and/or couplers. In at least one example, any or all of the modules can include one or more drip detectors, such as coupled to the drip tray. In at least one example, any or all of the modules can include one or more lamps, which can direct light into the aisle. In at least one example, any or all of the modules can include a perimeter frame. In at least one example, the perimeter frame can span the aisle and/or be coupled to the perimeter frame of an adjacent module. In at least one example, the perimeter frame can be coupled to the respective opposing pair of the cabinets. In at least one example, the tubes and/or couplers can be coupled to the perimeter frame.

In at least one example, any or all of the modules can include multiple sets of the tubes. In at least one example, the first tubes, the second tubes, the third tubes, or any combination thereof can be disposed above a first side of the aisle. In at least one example, any or all of the through modules can include a fourth tube for receiving cooling fluid flow in a third direction, a fifth tube for receiving cooling fluid flow in a fourth direction (such as opposite the third), a sixth tube for receiving cooling fluid flow in the third direction. In at least one example, the third direction can be the same as the first direction. In at least one example, the fourth direction can be the same as the second direction. In at least one example, any or all of the directions can be different. In at least one example, the fourth tubes, the fifth tubes, the sixth tubes, or any combination thereof can be disposed above a second, opposite side of the aisle.

In at least one example, the end module can include another reversing coupler for coupling the fourth tube and the fifth tube of the first through module. In at least one example, the system can include one or more caps for capping, or plugging, the sixth tube of the first through module and/or for capping, or plugging, the fourth tube of one or more of the through modules. In at least one example, the system can include a fourth straight coupler for coupling the fourth tube of the first through module with the fourth tube of the second through module, a fifth straight coupler for coupling the fifth tube of the first through module with the fifth tube of the second through module, a sixth straight coupler for coupling the sixth tube of the first through module with the sixth tube of the second through module, or any combination thereof.

In at least one example, the system can include a first cooling fluid distribution unit disposed on the first side of the aisle for inducing cold cooling fluid to flow into the third tubes, flowing in the first direction, and/or receiving warm cooling fluid from the second tubes, flowing in the second direction. In at least one example, the system can include a second cooling fluid distribution unit disposed on the second side of the aisle for inducing cold cooling fluid to flow into the sixth tubes, flowing in the first direction, and/or receiving warm cooling fluid from the fifth tubes, flowing in the second direction. In at least one example, any or all of the through modules can include a third tap coupled to its sixth tube for directing the cold cooling fluid from its sixth tube to a second one of the cabinets and/or a fourth tap coupled to its fourth tube for receiving warm cooling fluid from the second (or another) one of the cabinets into its fourth tube.

In at least one example, the first cooling fluid distribution unit, disposed on the first side of the aisle, can induce cold cooling fluid to flow into the second tubes, flowing in the second direction, and/or receive warm cooling fluid from the third tubes, flowing in the first direction. In at least one example, the second cooling fluid distribution unit, disposed on the second side of the aisle, can induce cold cooling fluid to flow into the fifth tubes, flowing in the second direction, and/or receive warm cooling fluid from the sixth tubes, flowing in the first direction. In at least one example, any or all of the through modules can include a third tap coupled to its fourth tube for directing the cold cooling fluid from its fourth tube to a second one of the cabinets and/or a fourth tap coupled to its sixth tube for receiving warm cooling fluid from the second (or another) one of the cabinets into its sixth tube.

In at least one example, the system can include a pipe frame coupled above the perimeter frame of any or all of the modules. In at least one example, the pipe frame can be coupled to a supply pipe and/or a return pipe. In at least one example, the pipe frame can be modular as well, with one or more individual pipe modules being as wide as respective ones of the through modules and/or the end modules. In at least one example, the pipe frame can be wider than the through modules and/or the end modules, and/or span multiple through modules and/or end modules.

In at least one example, the pipes can extract heat from the cabinets and/or the cooling fluid. In at least one example, the pipes can extract heat from the cabinets through or via the cooling fluid. In at least one example, the first cooling fluid distribution unit, such as disposed on the first side of the aisle, can induce a first primary cooling fluid to flow through the first tubes, the second tubes, the third tubes, or any combination thereof. In at least one example, the second cooling fluid distribution unit, such as disposed on the second side of the aisle, can induce a second primary cooling fluid to flow through the fourth tubes, the fifth tubes, the sixth tubes, or any combination thereof. In at least one example, the supply pipe can supply the first primary cooling fluid to the first cooling fluid distribution unit and/or the second primary cooling fluid to the second cooling fluid distribution unit. In at least one example, the return pipe can receive the first primary cooling fluid from the first cooling fluid distribution unit and/or the second primary cooling fluid from the second cooling fluid distribution unit.

In at least one example, the system can thermally couple and/or physically isolate any of the cooling fluids. In at least one example, the supply pipe can supply a secondary cooling fluid and/or the return pipe can receive the secondary cooling fluid. In at least one example, the cooling fluid distribution units can transfer heat from either or both of the primary cooling fluids to the secondary cooling fluid, such as through a fluid-to-fluid heat exchanger.

In at least one example, the system can include an electrical frame coupled above the perimeter frame of each through module and/or coupled above the pipe frame. In at least one example, the electrical frame can be modular as well, with one or more individual electrical modules being as wide as respective ones of the through modules and/or the end modules. In at least one example, the electrical frame can be wider than the through modules and/or the end modules, and/or span multiple through modules and/or end modules. In at least one example, the electrical frame can be wider than the pipe modules and/or span multiple pipe modules. In at least one example, the electrical frame can be wider than the through modules and/or the end modules, but narrower than the pipe modules.

In at least one example, the electrical frame can include one or more cable trays for receiving one or more electrical cables. In at least one example, the electrical frame can include one or more junction boxes for facilitating coupling the electrical cables to the cabinets, such as to computer equipment within the cabinets. In at least one example, the electrical cables can provide power and/or communications to the cabinets, such as to computer equipment within the cabinets.

### BRIEF DESCRIPTION OF THE DRAWINGS

FIG. 1 is a perspective view of one of many examples of a modular data center infrastructure system according to the disclosure.
FIG. 2 is a side elevation view of the modular data center infrastructure system of FIG. 1.
FIG. 3 is an end elevation view of the modular data center infrastructure system of FIG. 1.
FIG. 4 is an exploded view of a portion of the modular data center infrastructure system of FIG. 1.
FIG. 5 is a perspective view of another one of many examples of a modular data center infrastructure system according to the disclosure.
FIG. 6 is a side elevation view of the modular data center infrastructure system of FIG. 5.
FIG. 7 is an end elevation view of the modular data center infrastructure system of FIG. 5.
FIG. 8 is an exploded view of a portion of the modular data center infrastructure system of FIG. 5.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for data center infrastructure. In at least one example, a modular data center infrastructure system according to the disclosure can quickly and easily be scaled to meet the needs of a variety of data centers. In at least one example, modules of the present disclosure can be pre-fabricated and arranged for simple on-site assembly (e.g., via hand tools) within an aisle of a data center, reducing or eliminating the need for on-site welding. In at least one example, the modular integration of direct liquid cooling helps ensure that high-performance computing needs are met seamlessly, boosting energy efficiency and overall performance. In at least one example, the modularity of the present system can promote quicker adoption cycles, reduced installation time, improved operational efficiency, and/or comprehensive, reliable performance.

In at least one example, a modular data center infrastructure system according to the disclosure can provide balanced cooling flow through a plurality of heat loads, such as by incorporating Tichelmann distribution, without on-site pipe balancing. In at least one example, a modular data center infrastructure system according to the disclosure can provide an integrated, plug-and-play solution that combines mechanical infrastructure, advanced secondary liquid cooling, cabling, leak containment, leak detection, internal lighting, power and/or communications, or any combination thereof. In at least one example, a modular data center infrastructure system according to the disclosure can provide faster deployment, reduced installation complexity, enhanced operational performance, resulting in improved resource allocation, higher uptime, and overall operational excellence.

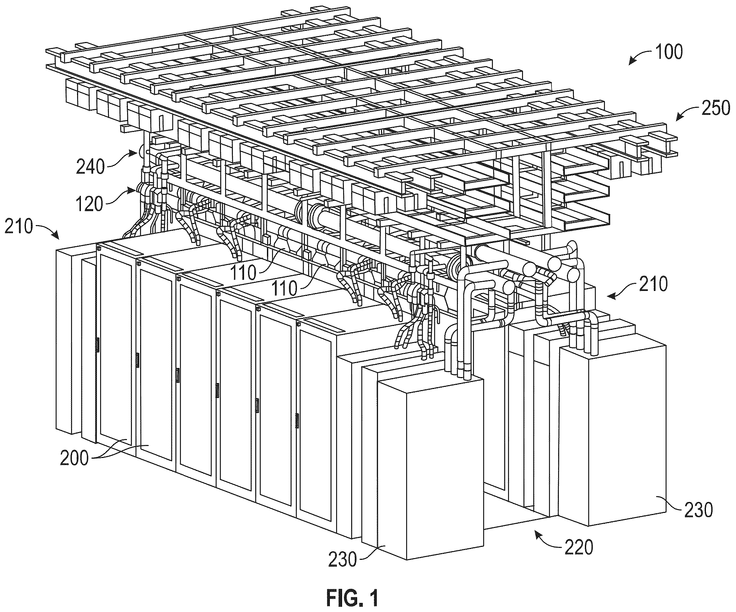

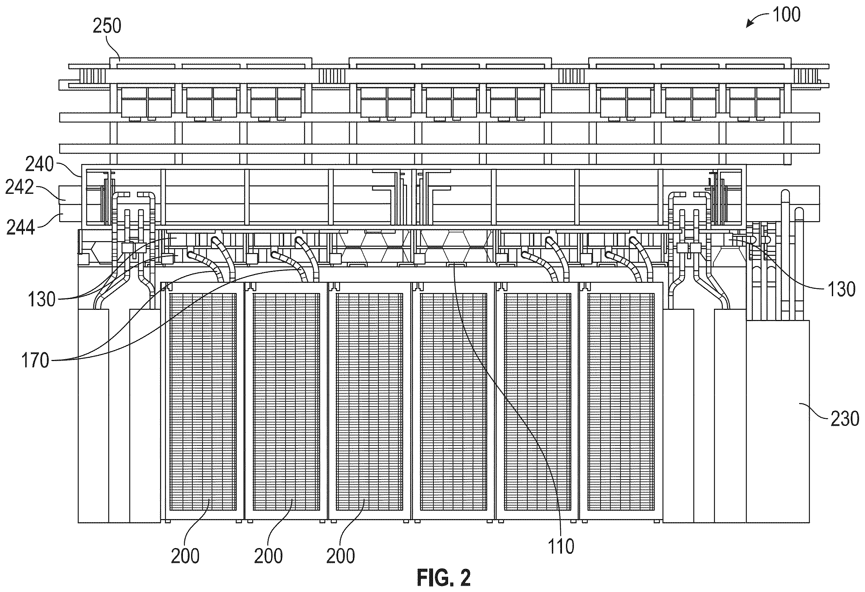

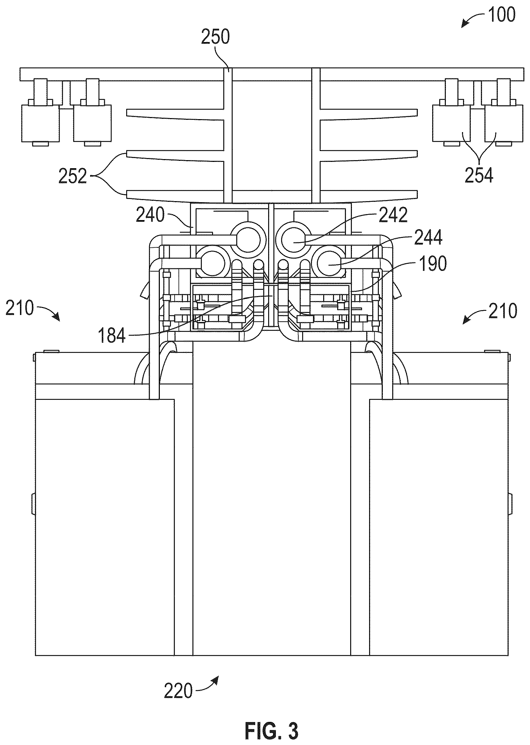

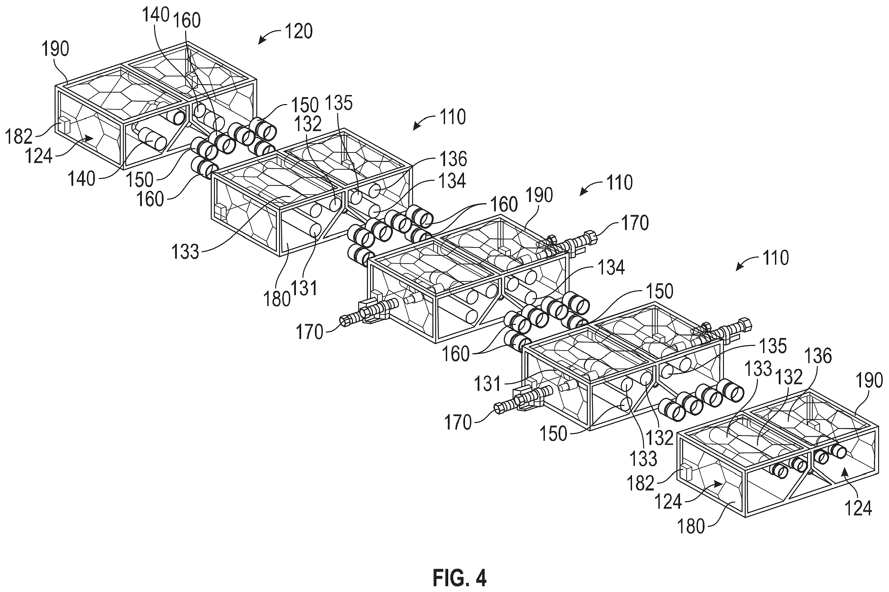

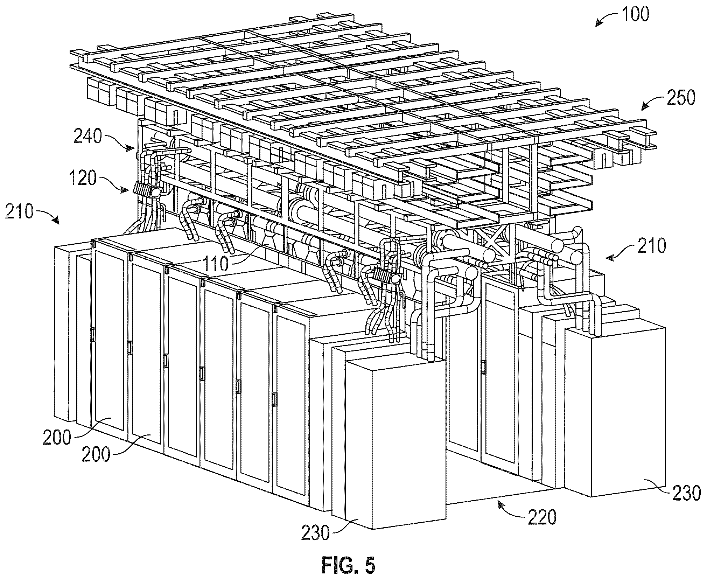

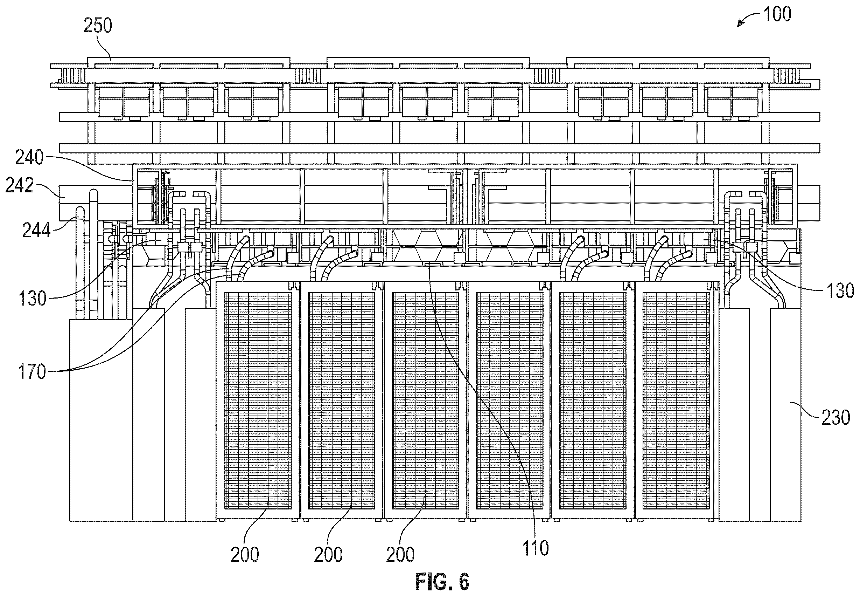

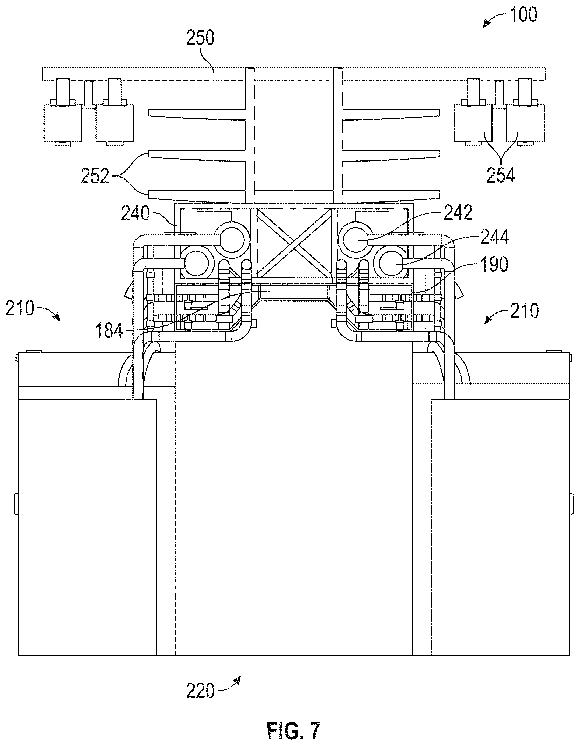

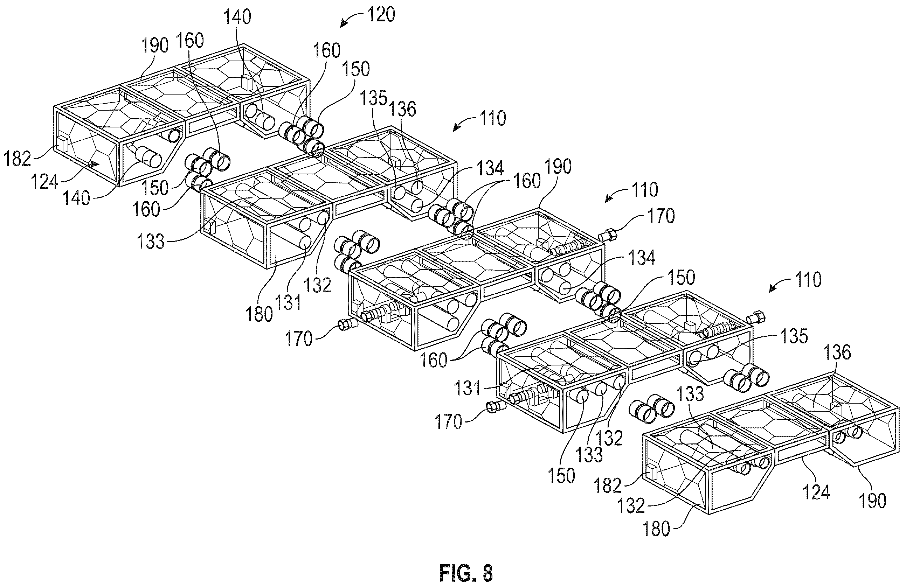

FIG. 1 is a perspective view of one of many examples of a modular data center infrastructure system according to the disclosure. FIG. 2 is a side elevation view of the modular data center infrastructure system of FIG. 1. FIG. 3 is an end elevation view of the modular data center infrastructure system of FIG. 1. FIG. 4 is an exploded view of a portion of the modular data center infrastructure system of FIG. 1. FIG. 5 is a perspective view of another one of many examples of a modular data center infrastructure system according to the disclosure. FIG. 6 is a side elevation view of the modular data center infrastructure system of FIG. 5. FIG. 7 is an end elevation view of the modular data center infrastructure system of FIG. 5. FIG. 8 is an exploded view of a portion of the modular data center infrastructure system of FIG. 5. FIGS. 1-8 are described in conjunction with one another.

In at least one example, a modular data center infrastructure system 100 according to the disclosure can provide infrastructure for one or more computer equipment cabinets 200, such as those found in data centers. For example, a data center can include two or more rows 210 of cabinets 200, such as in standardized sizes, with an aisle 220 between pairs of rows 210. In at least one example, the aisle 220 can be a hot aisle for receiving hot air from the cabinets 200. In at least one example, the aisle 220 can be a cold aisle for providing cold air to the cabinets 200, such as to cool computer equipment therein. In at least one example, a modular data center infrastructure system 100 according to the disclosure can provide a roof for the aisle 220, helping to control the flow of the hot and/or cold air therein. In at least one example, a modular data center infrastructure system 100 according to the disclosure can include one or more ducts and/or one or more vents for helping to control the flow of the hot and/or cold air therethrough.

In at least one example, a modular data center infrastructure system 100 according to the disclosure can include one or more through modules 110 and one or more end modules 120. In at least one example, any or all of the modules 110, 120 can be disposed above one or more cabinets 200. In at least one example, any or all of the modules 110, 120 can be disposed above an aisle 220 between two rows 210 of cabinets 200, and/or coupled to opposing pairs of the cabinets 200. In at least one example, any or all of the modules 110, 120 can be coupled to one another. For example, the system 100 can include a first through module 110 coupled above a first opposing pair of the cabinets 200, a second through module 110 coupled to the first through module 110 and/or above a second opposing pair of the cabinets 200, an end module 120 coupled to one of the through modules 110 and/or above a third opposing pair of the cabinets 200, or any combination thereof. In at least one example, the first through module 110 can be coupled between the end module 120 and the second through module 110.

In at least one example, any or all of the modules 110, 120 can be as wide as the cabinets 200 to which they are coupled. In at least one example, the first through module 110 can have a first width of the first opposing pair of the cabinets 200. In at least one example, the second through module 110 can have a second width of the second opposing pair of the cabinets 200. In at least one example, the end module 120 can have a third width of the third opposing pair of the cabinets 200. The first width, the second width, the third width, or any combination thereof can be the same or different.

For example, many computer equipment cabinets 200 incorporate standard nineteen-inch racks. However, the cabinets 200 themselves can be between twenty-three and thirty-two inches wide. In at least one example, any or all of the modules 110, 120 can be between twenty-three and thirty-two inches wide. In at least one example, any or all of the modules 110, 120 can be six-hundred millimeters wide. In at least one example, any or all of the modules 110, 120 can be eight-hundred millimeters wide.

In at least one example, any or all of the modules 110, 120 can be as long, or longer, as the aisle 220 is wide and/or can span the aisle 220. In at least one example, each of the modules 110, 120 can be as long as the aisle 220 is wide. In at least one example, each of the modules 110, 120 can be longer than the aisle 220 is wide, such as to allow the modules 110, 120 to rest atop the cabinets 200 on either side of the aisle 220. In at least one example, any of the modules 110, 120 can be shorter than the aisle 220 is wide and/or be supported by other modules 110, 120.

In at least one example, the aisle 220 can be between one-thousand and two-thousand millimeters wide. In at least one example, any of the modules 110, 120 can be between one-thousand and two-thousand millimeters long. In at least one example, the aisle 220 can be twelve-hundred millimeters wide. In at least one example, any of the modules 110, 120 can be twelve-hundred millimeters long or slightly longer, such as between twelve-hundred millimeters and thirteen-hundred millimeters long. In at least one example, the aisle 220 can be eighteen-hundred millimeters wide. In at least one example, any of the modules 110, 120 can be eighteen-hundred millimeters long or slightly longer, such as between eighteen-hundred millimeters and nineteen-hundred millimeters long.

In at least one example, any or all of the modules 110, 120 can include one or more tubes 130 for receiving and/or directing cooling fluid flow. In at least one example, any or all of the modules 110, 120 can include a first tube 131 for receiving cooling fluid flow in a first direction, a second tube 132 for receiving cooling fluid flow in a second direction, a third tube 133 for receiving cooling fluid flow in the first direction, or any combination thereof. In at least one example, the second direction can be opposite the first direction. In at least one example, the first direction and/or the second direction can be aligned with the aisle 220 and/or the row(s) 210 of cabinets 200. In at least one example, the end module 120, or the system 100 generally, can include a reversing coupler 140 for coupling the first tube 131 of the first through module 110 with the second tube 132 of the first through module 110. In at least one example, the reversing coupler 140 can redirect cooling fluid in the first tube 131, flowing in the first direction, to the second tube 132, flowing in the second direction and/or vice versa. In at least one example, any of the modules 110, 120, or the system 100 generally, can include a cap 150 for capping, or plugging, the third tube 133 of the first through module 110. In at least one example, any of the modules 110, 120, or the system 100 generally, can include another cap 150 for capping, or plugging, the first tube 131 of that through module 110. In at least one example, the caps 150 can stop cooling fluid flow at that module 110, 120.

In at least one example, any or all of the modules 110, 120, or the system 100 generally, can include one or more straight couplers 160 to couple adjacent ones of the tubes 130. In at least one example, the system 100 can include a first straight coupler 160 for coupling the first tube 131 of the first through module 110 with the first tube 131 of the second through module 110, a second straight coupler 160 for coupling the second tube 132 of the first through module 110 with the second tube 132 of the second through module 110, a third straight coupler 160 for coupling the third tube 133 of the first through module 110 with the third tube 133 of the second through module 110, or any combination thereof.

In at least one example, the system 100 can include one or more cooling fluid distribution units 230 for inducing cooling fluid flow through the tubes 130. In at least one example, the system 100 can include a cooling fluid distribution unit 230 for inducing cold cooling fluid to flow into the third tubes 133, such as flowing in the first direction, and/or receiving warm cooling fluid from the second tubes 132, such as flowing in the second direction. In at least one example, any or all of the modules 110, 120 can include one or more taps 170 coupled to one or more of the tubes 130 to direct the cooling fluid to and/or from one or more of the cabinets 200. In at least one example, any or all of the modules 110, 120 can include a first tap 170 coupled to its third tube 133 for directing the cold cooling fluid from its third tube 133 to a first one of the cabinets 200 and/or a second tap 170 coupled to its first tube 131 for receiving warm cooling fluid from the first one of the cabinets 200 into its first tube 131. In at least one example, the first tap 170 can direct the cold cooling fluid to one cabinet 200 and/or the second tap 170 can receive warm cooling fluid from another one of the cabinets 200.

In at least one example, the cooling fluid flow can be reversed. In at least one example, the cooling fluid distribution unit 230 can induce the cold cooling fluid to flow into the second tubes 132, flowing in the second direction, and/or receive the warm cooling fluid from the third tubes 133, flowing in the first direction. In at least one example, any or all of the modules 110, 120 can include a first tap 170 coupled to its first tube 131 and configured to direct the cold cooling fluid from its first tube 131 to a first one of the cabinets 200 and/or a second tap 170 coupled to its third tube 133 and configured to receive warm cooling fluid from the first (or another) one of the cabinets 200 into its third tube 133.

In at least one example, the system 100 can provide balanced flow of the cooling fluid, such as by incorporating Tichelmann distribution, using the tubes 130. In at least one example, the system 100 can equalize a total flow distance of the cooling fluid across any or all of the cabinets 200 using the tubes 130. In at least one example, the cooling fluid distribution unit 230 can induce cooling fluid flow in the second tubes 132 and the third tubes 133, in different directions. In at least one example, the reversing coupler 140 can redirect flow to and/or from the second tube 132 to and/or from the first tube 131 reversing the direction of flow. In at least one example, the taps 170 can direct the cooling fluid to and/or from one or more of the cabinets 200, to and/or from the first tubes 131 and/or the third tubes 133, where the cooling fluid can flow in the same direction. In at least one example, cooling fluid flowing through a cabinet 200 at one end of the row 210 can travel the same total distance as cooling fluid flowing through another cabinet 200 at an opposite end of the row 210.

In at least one example, any or all of the modules 110, 120 can include one or more drip trays 180 disposed below the tubes 130, the couplers 140, 160, the caps 150, the taps 170, or any combination thereof. In at least one example, any or all of the modules 110, 120 can include one or more drip detectors 182, such as coupled to the drip tray 180 (e.g., mounted within the drip tray 180). In at least one example, any or all of the modules 110, 120 can include one or more lamps 184, which can direct light into the aisle 220 and/or towards any of the rows 210 of cabinet 200.

In at least one example, any or all of the modules 110, 120 can include a perimeter frame 190. In at least one example, the perimeter frame 190 can span the aisle 220 and/or be coupled to the perimeter frame 190 of an adjacent module 110, 120. In at least one example, the perimeter frame 190 can be coupled to the respective opposing pair of the cabinets 200. In at least one example, the tubes 130, the couplers 140, 160, the caps 150, the taps 170, the trip tray 180, the drip detector 182, the lamp 184, or any combination thereof can be coupled to the perimeter frame 190.

In at least one example, any or all of the modules 110, 120 can include multiple sets of the tubes 130. In at least one example, the first tubes 131, the second tubes 132, the third tubes 133, or any combination thereof can be disposed above a first side of the aisle 220. In at least one example, any or all of the modules 110, 120 can include a fourth tube 134 for receiving cooling fluid flow in a third direction, a fifth tube 135 for receiving cooling fluid flow in a fourth direction (such as opposite the third), a sixth tube 136 for receiving cooling fluid flow in the third direction. In at least one example, the third direction can be the same as the first direction. In at least one example, the fourth direction can be the same as the second direction. In at least one example, any or all of the directions can be different. In at least one example, the fourth tubes 134, the fifth tubes 135, the sixth tubes 136, or any combination thereof can be disposed above a second, opposite side of the aisle 220.

In at least one example, the end module 120, and/or the system 100 generally, can include another reversing coupler 140 for coupling the fourth tube 134 and the fifth tube 135 of the first through module 110. In at least one example, the system 100 can include one or more caps 150 for capping, or plugging, the sixth tube 136 of the first through module 110 and/or the fourth tube 134 of one or more of the through modules 110. In at least one example, the system 100 can include a fourth straight coupler 160 for coupling the fourth tube 134 of the first through module 110 with the fourth tube 134 of the second through module 110, a fifth straight coupler 160 for coupling the fifth tube 135 of the first through module 110 with the fifth tube 135 of the second through module 110, a sixth straight coupler 160 for coupling the sixth tube 136 of the first through module 110 with the sixth tube 136 of the second through module 110, or any combination thereof.

In at least one example, the system 100 can include a first cooling fluid distribution unit 230 disposed on the first side of the aisle 220 for inducing cold cooling fluid to flow into the third tubes 133, flowing in the first direction, and/or receiving warm cooling fluid from the second tubes 132, flowing in the second direction. In at least one example, the system 100 can include a second cooling fluid distribution unit 230 disposed on the second side of the aisle 200 for inducing cold cooling fluid to flow into the sixth tubes 136, flowing in the first direction, and/or receiving warm cooling fluid from the fifth tubes 135, flowing in the second direction. In at least one example, any or all of the modules 110, 120 can include a third tap 170 coupled to its sixth tube 136 for directing the cold cooling fluid from its sixth tube 136 to a second one of the cabinets 200 and/or a fourth tap 170 coupled to its fourth tube 134 for receiving warm cooling fluid from the second (or another) one of the cabinets 200 into its fourth tube 134.

In at least one example, the first cooling fluid distribution unit 230, which can be disposed on the first side of the aisle 220, can induce cold cooling fluid to flow into the second tubes 132, flowing in the second direction, and/or receive warm cooling fluid from the third tubes 133, flowing in the first direction. In at least one example, the second cooling fluid distribution unit 230, which can be disposed on the second side of the aisle 220, can induce cold cooling fluid to flow into the fifth tubes 135, flowing in the second direction, and/or receive warm cooling fluid from the sixth tubes 136, flowing in the first direction. In at least one example, any or all of the modules 110, 120 can include a third tap 170 coupled to its fourth tube 134 for directing the cold cooling fluid from its fourth tube 134 to a second one of the cabinets 200 and/or a fourth tap 170 coupled to its sixth tube 136 for receiving warm cooling fluid from the second (or another) one of the cabinets 200 into its sixth tube 136.

In at least one example, the system can include a pipe frame 240 coupled above the perimeter frame 190 of any or all of the modules 110, 120. In at least one example, the pipe frame 240 can be coupled to a supply pipe 242 and/or a return pipe 244. In at least one example, the pipe frame 240 can be modular as well, with one or more individual pipe modules being as wide as respective ones of the through modules 110 and/or the end modules 120. In at least one example, the pipe frame 240 can be wider than the through modules 110 and/or the end modules 120, and/or span one or more through modules 110 and/or end modules 120.

In at least one example, the pipes 242, 244 can extract heat from the cabinets 200 and/or the cooling fluid. In at least one example, the pipes 242, 244 can extract heat from the cabinets 200 through or via the cooling fluid. In at least one example, the first cooling fluid distribution unit 230, such as disposed on the first side of the aisle 220, can induce a first primary cooling fluid to flow through the first tubes 131, the second tubes 132, the third tubes 133, or any combination thereof. In at least one example, the second cooling fluid distribution unit 230, such as disposed on the second side of the aisle 220, can induce a second primary cooling fluid to flow through the fourth tubes 134, the fifth tubes 135, the sixth tubes 136, or any combination thereof. In at least one example, the supply pipe 242 can supply the first primary cooling fluid to the first cooling fluid distribution unit 230 and/or the second primary cooling fluid to the second cooling fluid distribution unit 230. In at least one example, the return pipe 244 can receive the first primary cooling fluid from the first cooling fluid distribution unit 230 and/or the second primary cooling fluid from the second cooling fluid distribution unit 230.

In at least one example, the system 100 can thermally couple and/or physically isolate any of the cooling fluids. In at least one example, a first supply pipe 242 can supply the first primary cooling fluid to the first cooling fluid distribution unit 230 and a second supply pipe 242 can supply the second primary cooling fluid to the second cooling fluid distribution unit 230. In at least one example, a first return pipe 244 can receive the first primary cooling fluid from the first cooling fluid distribution unit 230 and a second return pipe 244 can receive the second primary cooling fluid from the second cooling fluid distribution unit 230. In at least one example, the supply pipe 242 can supply a secondary cooling fluid and/or the return pipe 244 can receive the secondary cooling fluid. In at least one example, the cooling fluid distribution units 230 can transfer heat from either or both of the primary cooling fluids to the secondary cooling fluid, such as through a fluid-to-fluid heat exchanger. In at least one example, the tubes 130, the couplers 140, 160, the caps 150, the taps 170, the pipes 242, 244, or any combination thereof can be cold-formed stainless steel.

In at least one example, the system 100 can include an electrical frame 250 coupled above the perimeter frame 190 of each through module 110 and/or end module 120. In at least one example, the system 100 can include an electrical frame 250 coupled above the pipe frame 240. In at least one example, the electrical frame 250 can be modular as well, with one or more individual electrical modules being as wide as respective ones of the through modules 110 and/or the end modules 120. In at least one example, the electrical frame 250 can be wider than the through modules 110 and/or the end modules 120, and/or span one or more through modules 110 and/or end modules 120. In at least one example, the electrical frame 250 can be wider than the pipe modules and/or span multiple pipe modules. In at least one example, the electrical frame 250 can be wider than the through modules 110 and/or the end modules 120, but narrower than the pipe modules.

In at least one example, the electrical frame 250 can include one or more cable trays 252 for receiving one or more electrical cables. In at least one example, the cable trays 252 can be six-hundred millimeters wide. In at least one example, the electrical frame 250 can include one or more junction boxes 254 for facilitating coupling the electrical cables to the cabinets 200, such as to computer equipment within the cabinets 200, the drip detector 182, the lamp 184, or any combination thereof. In at least one example, the electrical cables can provide power and/or communications to the cabinets 200, such as to computer equipment within the cabinets 200, the drip detector 182, the lamp 184, or any combination thereof.

In at least one example, the through modules 110, the end modules 120, the pipe modules, the electrical modules, or any combination thereof can be at least partially enclosed with one or more panels 124, such as one or more top panels, bottom panels and/or side panels (see, e.g., FIGS. 4 and 8). In at least one example, one or more of the panels 124 can support aisle containment, such as by helping maintain a differential pressure between a hot aisle and a cold aisle. In at least one example, any or all of the panels can be removable, such as for providing access for maintenance of the through modules 110, the end modules 120, the pipe modules, the electrical modules, or any combination thereof. In at least one example, the system 100 can provide air and/or fluid based cooling capability for the cabinets 200, and/or equipment within the cabinets 200, in a modular, easily specified and assembled, i.e., plug-and-play, solution, unlike conventional systems that require extensive on-site customization.

In at least one example, a modular data center infrastructure system according to the disclosure can include one or more through modules and one or more end modules. In at least one example, any or all of the modules can be disposed above one or more cabinets, such as computer equipment cabinets. In at least one example, any or all of the modules can be disposed above an aisle between two rows of cabinets, and/or coupled to opposing pairs of the cabinets. In at least one example, any or all of the modules can be coupled to one another. For example, the system can include a first through module coupled above a first opposing pair of the cabinets, a second through module coupled to the first through module and/or above a second opposing pair of the cabinets, an end module coupled to one of the through modules and/or above a third opposing pair of the cabinets, or any combination thereof. In at least one example, the first through module can be coupled between the end module and the second through module.

In at least one example, any or all of the modules can be as wide as the cabinets to which they are coupled. In at least one example, the first through module can have a first width of the first opposing pair of the cabinets. In at least one example, the second through module can have a second width of the second opposing pair of the cabinets. In at least one example, the end module can have a third width of the third opposing pair of the cabinets. The first width, the second width, the third width, or any combination thereof can be the same or different.

In at least one example, any or all of the modules can be as long, or longer, as the aisle is wide and/or can span the aisle. In at least one example, each of the modules can be as long than the aisle is wide. In at least one example, each of the modules can be longer than the aisle is wide. In at least one example, any of the modules can be shorter than the aisle is wide and/or be supported by other modules.

In at least one example, each through module can include a first tube for receiving cooling fluid flow in a first direction, a second tube for receiving cooling fluid flow in a second direction, a third tube for receiving cooling fluid flow in the first direction, or any combination thereof. In at least one example, the second direction can be opposite the first direction. In at least one example, the first direction and/or the second direction can be aligned with the aisle and/or the row(s) of cabinets. In at least one example, the end module, or the system generally, can include a reversing coupler for coupling the first tube of the first through module with the second tube of the first through module. In at least one example, the reversing coupler can redirect cooling fluid in the first tube, flowing in the first direction, to the second tube, flowing in the second direction and/or vice versa. In at least one example, the end module, or the system generally, can include a cap for capping, or plugging, the third tube of the first through module. In at least one example, any of the through modules, or the system generally, can include another cap for capping, or plugging, the first tube of that through module.

In at least one example, any or all of the through modules, or the system generally, can include one or more straight couplers to couple adjacent ones of the tubes. In at least one example, the system can include a first straight coupler for coupling the first tube of the first through module with the first tube of the second through module, a second straight coupler for coupling the second tube of the first through module with the second tube of the second through module, a third straight coupler for coupling the third tube of the first through module with the third tube of the second through module, or any combination thereof.

In at least one example, the system can include one or more cooling fluid distribution units for inducing cooling fluid flow through the tubes. In at least one example, the system can include a cooling fluid distribution unit for inducing cold cooling fluid to flow into the third tubes, such as flowing in the first direction, and/or receiving warm cooling fluid from the second tubes, such as flowing in the second direction. In at least one example, any or all of the through modules can include a first tap coupled to its third tube for directing the cold cooling fluid from its third tube to a first one of the cabinets and/or a second tap coupled to its first tube for receiving warm cooling fluid from the first one of the cabinets into its first tube. In at least one example, the first tap can direct the cold cooling fluid to one cabinet and/or the second tap can receive warm cooling fluid from another one of the cabinets.

In at least one example, the cooling fluid flow can be reversed. In at least one example, the cooling fluid distribution unit can induce the cold cooling fluid to flow into the second tubes, flowing in the second direction, and/or receive the warm cooling fluid from the third tubes, flowing in the first direction. In at least one example, any or all of the through modules can include a first tap coupled to its first tube and configured to direct the cold cooling fluid from its first tube to a first one of the cabinets and/or a second tap coupled to its third tube and configured to receive warm cooling fluid from the first (or another) one of the cabinets into its third tube.

In at least one example, any or all of the modules can include one or more drip trays disposed below the tubes and/or couplers. In at least one example, any or all of the modules can include one or more drip detectors, such as coupled to the drip tray. In at least one example, any or all of the modules can include one or more lamps, which can direct light into the aisle. In at least one example, any or all of the modules can include a perimeter frame. In at least one example, the perimeter frame can span the aisle and/or be coupled to the perimeter frame of an adjacent module. In at least one example, the perimeter frame can be coupled to the respective opposing pair of the cabinets. In at least one example, the tubes and/or couplers can be coupled to the perimeter frame.

In at least one example, any or all of the modules can include multiple sets of the tubes. In at least one example, the first tubes, the second tubes, the third tubes, or any combination thereof can be disposed above a first side of the aisle. In at least one example, any or all of the through modules can include a fourth tube for receiving cooling fluid flow in a third direction, a fifth tube for receiving cooling fluid flow in a fourth direction (such as opposite the third), a sixth tube for receiving cooling fluid flow in the third direction. In at least one example, the third direction can be the same as the first direction. In at least one example, the fourth direction can be the same as the second direction. In at least one example, any or all of the directions can be different. In at least one example, the fourth tubes, the fifth tubes, the sixth tubes, or any combination thereof can be disposed above a second, opposite side of the aisle.

In at least one example, the end module can include another reversing coupler for coupling the fourth tube and the fifth tube of the first through module. In at least one example, the system can include one or more caps for capping, or plugging, the sixth tube of the first through module and/or for capping, or plugging, the fourth tube of one or more of the through modules. In at least one example, the system can include a fourth straight coupler for coupling the fourth tube of the first through module with the fourth tube of the second through module, a fifth straight coupler for coupling the fifth tube of the first through module with the fifth tube of the second through module, a sixth straight coupler for coupling the sixth tube of the first through module with the sixth tube of the second through module, or any combination thereof.

In at least one example, the system can include a first cooling fluid distribution unit disposed on the first side of the aisle for inducing cold cooling fluid to flow into the third tubes, flowing in the first direction, and/or receiving warm cooling fluid from the second tubes, flowing in the second direction. In at least one example, the system can include a second cooling fluid distribution unit disposed on the second side of the aisle for inducing cold cooling fluid to flow into the sixth tubes, flowing in the first direction, and/or receiving warm cooling fluid from the fifth tubes, flowing in the second direction. In at least one example, any or all of the through modules can include a third tap coupled to its sixth tube for directing the cold cooling fluid from its sixth tube to a second one of the cabinets and/or a fourth tap coupled to its fourth tube for receiving warm cooling fluid from the second (or another) one of the cabinets into its fourth tube.

In at least one example, the first cooling fluid distribution unit, disposed on the first side of the aisle, can induce cold cooling fluid to flow into the second tubes, flowing in the second direction, and/or receive warm cooling fluid from the third tubes, flowing in the first direction. In at least one example, the second cooling fluid distribution unit, disposed on the second side of the aisle, can induce cold cooling fluid to flow into the fifth tubes, flowing in the second direction, and/or receive warm cooling fluid from the sixth tubes, flowing in the first direction. In at least one example, any or all of the through modules can include a third tap coupled to its fourth tube for directing the cold cooling fluid from its fourth tube to a second one of the cabinets and/or a fourth tap coupled to its sixth tube for receiving warm cooling fluid from the second (or another) one of the cabinets into its sixth tube.

In at least one example, the system can include a pipe frame coupled above the perimeter frame of any or all of the modules. In at least one example, the pipe frame can be coupled to a supply pipe and/or a return pipe. In at least one example, the pipe frame can be modular as well, with one or more individual pipe modules being as wide as respective ones of the through modules and/or the end modules. In at least one example, the pipe frame can be wider than the through modules and/or the end modules, and/or span multiple through modules and/or end modules.

In at least one example, the pipes can extract heat from the cabinets and/or the cooling fluid. In at least one example, the pipes can extract heat from the cabinets through or via the cooling fluid. In at least one example, the first cooling fluid distribution unit, such as disposed on the first side of the aisle, can induce a first primary cooling fluid to flow through the first tubes, the second tubes, the third tubes, or any combination thereof. In at least one example, the second cooling fluid distribution unit, such as disposed on the second side of the aisle, can induce a second primary cooling fluid to flow through the fourth tubes, the fifth tubes, the sixth tubes, or any combination thereof. In at least one example, the supply pipe can supply the first primary cooling fluid to the first cooling fluid distribution unit and/or the second primary cooling fluid to the second cooling fluid distribution unit. In at least one example, the return pipe can receive the first primary cooling fluid from the first cooling fluid distribution unit and/or the second primary cooling fluid from the second cooling fluid distribution unit.

In at least one example, the system can thermally couple and/or physically isolate any of the cooling fluids. In at least one example, the supply pipe can supply a secondary cooling fluid and/or the return pipe can receive the secondary cooling fluid. In at least one example, the cooling fluid distribution units can transfer heat from either or both of the primary cooling fluids to the secondary cooling fluid, such as through a fluid-to-fluid heat exchanger.

In at least one example, the system can include an electrical frame coupled above the perimeter frame of each through module and/or coupled above the pipe frame. In at least one example, the electrical frame can be modular as well, with one or more individual electrical modules being as wide as respective ones of the through modules and/or the end modules. In at least one example, the electrical frame can be wider than the through modules and/or the end modules, and/or span multiple through modules and/or end modules. In at least one example, the electrical frame can be wider than the pipe modules and/or span multiple pipe modules. In at least one example, the electrical frame can be wider than the through modules and/or the end modules, but narrower than the pipe modules.

In at least one example, the electrical frame can include one or more cable trays for receiving one or more electrical cables. In at least one example, the electrical frame can include one or more junction boxes for facilitating coupling the electrical cables to the cabinets, such as to computer equipment within the cabinets. In at least one example, the electrical cables can provide power and/or communications to the cabinets, such as to computer equipment within the cabinets.

The devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

Described herein are also the following clauses:
1. A modular data center infrastructure system for providing cooling to two rows of computer equipment cabinets having an aisle therebetween, the system comprising: a plurality of through modules configured to be disposed above the aisle; wherein the plurality of through modules includes a first through module configured to be coupled above a first opposing pair of the cabinets and a second through module configured to be coupled to the first through module above a second opposing pair of the cabinets; wherein the first through module has a first width of the first opposing pair of the cabinets and the second through module has a second width of the second opposing pair of the cabinets; and wherein each through module includes a first tube configured to receive cooling fluid flow in a first direction, a second tube configured to receive cooling fluid flow in a second, opposite direction, and a third tube configured to receive cooling fluid flow in the first direction; an end module configured to be disposed above the aisle and coupled above a third opposing pair of the cabinets; wherein the end module has a third width of the third opposing pair of the cabinets; and wherein the through modules and the end module are configured to be coupled to one another with the first through module being coupled between the end module and the second through module; and a first reversing coupler configured to couple the first tube of the first through module with the second tube of the first through module.
2. The system as set forth in clause 1, further comprising a first straight coupler configured to couple the first tube of the first through module with the first tube of the second through module, a second straight coupler configured to couple the second tube of the first through module with the second tube of the second through module, and a third straight coupler configured to couple the third tube of the first through module with the third tube of the second through module.
3. The system as set forth in clause 1, further comprising a first cap configured to cap the third tube of the first through module.
4. The system as set forth in clause 1, further comprising a cooling fluid distribution unit configured to induce cold cooling fluid to flow into the third tubes, flowing in the first direction, and receive warm cooling fluid from the second tubes, flowing in the second direction.
5. The system as set forth in clause 4, wherein at least one of the through modules includes a first tap coupled to its third tube and configured to direct the cold cooling fluid from its third tube to a first one of the cabinets, and a second tap coupled to its first tube and configured to receive warm cooling fluid from the first one of the cabinets into its first tube.
6. The system as set forth in clause 1, further comprising a cooling fluid distribution unit configured to induce cold cooling fluid to flow into the second tubes, flowing in the second direction, and receive warm cooling fluid from the third tubes, flowing in the first direction.
7. The system as set forth in clause 6, wherein at least one of the through modules includes a first tap coupled to its first tube and configured to direct the cold cooling fluid from its first tube to a first one of the cabinets, and a second tap coupled to its third tube and configured to receive warm cooling fluid from the first one of the cabinets into its third tube.
8. The system as set forth in clause 1, wherein each through module includes a drip tray disposed below its tubes.
9. The system as set forth in clause 8, wherein at least one of the through modules includes a drip detector coupled to the drip tray.
10. The system as set forth in clause 1, wherein at least one of the through modules includes a lamp configured to direct light into the aisle.
11. The system as set forth in clause 1, wherein each through module includes a perimeter frame spanning the aisle; wherein the perimeter frame is coupled to the respective opposing pair of the cabinets; and wherein the tubes are coupled to the perimeter frame.
12. The system as set forth in clause 1, wherein the first tubes, the second tubes, and the third tubes are disposed above a first side of the aisle; wherein each through module further includes a fourth tube configured to receive cooling fluid flow in the first direction, a fifth tube configured to receive cooling fluid flow in the second direction, and a sixth tube configured to receive cooling fluid flow in the first direction; wherein the fourth tubes, the fifth tubes, and the sixth tubes are disposed above a second, opposite side of the aisle; and further comprising a second reversing coupler configured to couple the fourth tube and the fifth tube of the first through module.
13. The system as set forth in clause 12, further comprising a first straight coupler configured to couple the first tube of the first through module with the first tube of the second through module, a second straight coupler configured to couple the second tube of the first through module with the second tube of the second through module, a third straight coupler configured to couple the third tube of the first through module with the third tube of the second through module, a fourth straight coupler configured to couple the fourth tube of the first through module with the fourth tube of the second through module, a fifth straight coupler configured to couple the fifth tube of the first through module with the fifth tube of the second through module, and a sixth straight coupler configured to couple the sixth tube of the first through module with the sixth tube of the second through module.
14. The system as set forth in clause 12, further comprising a first cap configured to cap the third tube of the first through module and a second cap configured to cap the sixth tube of the first through module.
15. The system as set forth in clause 12, further comprising a first cooling fluid distribution unit disposed on the first side of the aisle and configured to induce cold cooling fluid to flow into the third tubes, flowing in the first direction, and receive warm cooling fluid from the second tubes, flowing in the second direction; and further comprising a second cooling fluid distribution unit disposed on the second side of the aisle and configured to induce cold cooling fluid to flow into the sixth tubes, flowing in the first direction, and receive warm cooling fluid from the fifth tubes, flowing in the second direction.
16. The system as set forth in clause 15, wherein at least one of the through modules includes a first tap coupled to its third tube and configured to direct the cold cooling fluid from its third tube to a first one of the cabinets, a second tap coupled to its first tube and configured to receive warm cooling fluid from the first one of the cabinets into its first tube, a third tap coupled to its sixth tube and configured to direct the cold cooling fluid from its sixth tube to a second one of the cabinets, and a fourth tap coupled to its fourth tube and configured to receive warm cooling fluid from the second one of the cabinets into its fourth tube.
17. The system as set forth in clause 12, further comprising a first cooling fluid distribution unit disposed on the first side of the aisle and configured to induce cold cooling fluid to flow into the second tubes, flowing in the second direction, and receive warm cooling fluid from the third tubes, flowing in the first direction; and further comprising a second cooling fluid distribution unit disposed on the second side of the aisle and configured to induce cold cooling fluid to flow into the fifth tubes, flowing in the second direction, and receive warm cooling fluid from the sixth tubes, flowing in the first direction.
18. The system as set forth in clause 17, wherein at least one of the through modules includes a first tap coupled to its first tube and configured to direct the cold cooling fluid from its first tube to a first one of the cabinets, a second tap coupled to its third tube and configured to receive warm cooling fluid from the first one of the cabinets into its third tube, a third tap coupled to its fourth tube and configured to direct the cold cooling fluid from its fourth tube to a second one of the cabinets, and a fourth tap coupled to its sixth tube and configured to receive warm cooling fluid from the second one of the cabinets into its sixth tube.
19. The system as set forth in clause 12, wherein each through module includes a perimeter frame spanning the aisle; wherein the perimeter frame is coupled to the respective opposing pair of the cabinets; and wherein the tubes are coupled to the perimeter frame.
20. The system as set forth in clause 19, further comprising a pipe frame coupled above the perimeter frame of each through module; wherein the pipe frame is coupled to a supply pipe and a return pipe; and wherein the pipes are configured to extract heat from the cabinets via the cooling fluid.

## Claims

1. A modular data center infrastructure system for providing cooling to two rows of computer equipment cabinets having an aisle therebetween, the system comprising:
a plurality of through modules configured to be disposed above the aisle;
wherein the plurality of through modules includes a first through module configured to be coupled above a first opposing pair of the cabinets and a second through module configured to be coupled to the first through module above a second opposing pair of the cabinets;
wherein the first through module has a first width of the first opposing pair of the cabinets and the second through module has a second width of the second opposing pair of the cabinets; and
wherein each through module includes a first tube configured to receive cooling fluid flow in a first direction, a second tube configured to receive cooling fluid flow in a second, opposite direction, and a third tube configured to receive cooling fluid flow in the first direction;
an end module configured to be disposed above the aisle and coupled above a third opposing pair of the cabinets;
wherein the end module has a third width of the third opposing pair of the cabinets; and
wherein the through modules and the end module are configured to be coupled to one another with the first through module being coupled between the end module and the second through module; and
a first reversing coupler configured to couple the first tube of the first through module with the second tube of the first through module.

2. The system as set forth in claim 1, further comprising a first straight coupler configured to couple the first tube of the first through module with the first tube of the second through module, a second straight coupler configured to couple the second tube of the first through module with the second tube of the second through module, and a third straight coupler configured to couple the third tube of the first through module with the third tube of the second through module.

3. The system as set forth in any preceding claim, further comprising a first cap configured to cap the third tube of the first through module.

4. The system as set forth in any preceding claim, further comprising a cooling fluid distribution unit configured to induce cold cooling fluid to flow into the third tubes, flowing in the first direction, and receive warm cooling fluid from the second tubes, flowing in the second direction;
and optionally, wherein at least one of the through modules includes a first tap coupled to its third tube and configured to direct the cold cooling fluid from its third tube to a first one of the cabinets, and a second tap coupled to its first tube and configured to receive warm cooling fluid from the first one of the cabinets into its first tube.

5. The system as set forth in any one of the claims 1 to 3, further comprising a cooling fluid distribution unit configured to induce cold cooling fluid to flow into the second tubes, flowing in the second direction, and receive warm cooling fluid from the third tubes, flowing in the first direction;
and optionally, wherein at least one of the through modules includes a first tap coupled to its first tube and configured to direct the cold cooling fluid from its first tube to a first one of the cabinets, and a second tap coupled to its third tube and configured to receive warm cooling fluid from the first one of the cabinets into its third tube.

6. The system as set forth in any preceding claim, wherein each through module includes a drip tray disposed below its tubes;
and optionally, wherein at least one of the through modules includes a drip detector coupled to the drip tray.

7. The system as set forth in any preceding claim, wherein at least one of the through modules includes a lamp configured to direct light into the aisle.

8. The system as set forth in any preceding claim, wherein each through module includes a perimeter frame spanning the aisle; wherein the perimeter frame is coupled to the respective opposing pair of the cabinets; and wherein the tubes are coupled to the perimeter frame.

9. The system as set forth in any preceding claim, wherein the first tubes, the second tubes, and the third tubes are disposed above a first side of the aisle; wherein each through module further includes a fourth tube configured to receive cooling fluid flow in the first direction, a fifth tube configured to receive cooling fluid flow in the second direction, and a sixth tube configured to receive cooling fluid flow in the first direction; wherein the fourth tubes, the fifth tubes, and the sixth tubes are disposed above a second, opposite side of the aisle; and further comprising a second reversing coupler configured to couple the fourth tube and the fifth tube of the first through module.

10. The system as set forth in claim 9, further comprising a first straight coupler configured to couple the first tube of the first through module with the first tube of the second through module, a second straight coupler configured to couple the second tube of the first through module with the second tube of the second through module, a third straight coupler configured to couple the third tube of the first through module with the third tube of the second through module, a fourth straight coupler configured to couple the fourth tube of the first through module with the fourth tube of the second through module, a fifth straight coupler configured to couple the fifth tube of the first through module with the fifth tube of the second through module, and a sixth straight coupler configured to couple the sixth tube of the first through module with the sixth tube of the second through module.

11. The system as set forth in claim 9, further comprising a first cap configured to cap the third tube of the first through module and a second cap configured to cap the sixth tube of the first through module.

12. The system as set forth in claim 9, further comprising a first cooling fluid distribution unit disposed on the first side of the aisle and configured to induce cold cooling fluid to flow into the third tubes, flowing in the first direction, and receive warm cooling fluid from the second tubes, flowing in the second direction; and further comprising a second cooling fluid distribution unit disposed on the second side of the aisle and configured to induce cold cooling fluid to flow into the sixth tubes, flowing in the first direction, and receive warm cooling fluid from the fifth tubes, flowing in the second direction;
and optionally, wherein at least one of the through modules includes a first tap coupled to its third tube and configured to direct the cold cooling fluid from its third tube to a first one of the cabinets, a second tap coupled to its first tube and configured to receive warm cooling fluid from the first one of the cabinets into its first tube, a third tap coupled to its sixth tube and configured to direct the cold cooling fluid from its sixth tube to a second one of the cabinets, and a fourth tap coupled to its fourth tube and configured to receive warm cooling fluid from the second one of the cabinets into its fourth tube.

13. The system as set forth in claim 9, further comprising a first cooling fluid distribution unit disposed on the first side of the aisle and configured to induce cold cooling fluid to flow into the second tubes, flowing in the second direction, and receive warm cooling fluid from the third tubes, flowing in the first direction; and further comprising a second cooling fluid distribution unit disposed on the second side of the aisle and configured to induce cold cooling fluid to flow into the fifth tubes, flowing in the second direction, and receive warm cooling fluid from the sixth tubes, flowing in the first direction;
and optionally, wherein at least one of the through modules includes a first tap coupled to its first tube and configured to direct the cold cooling fluid from its first tube to a first one of the cabinets, a second tap coupled to its third tube and configured to receive warm cooling fluid from the first one of the cabinets into its third tube, a third tap coupled to its fourth tube and configured to direct the cold cooling fluid from its fourth tube to a second one of the cabinets, and a fourth tap coupled to its sixth tube and configured to receive warm cooling fluid from the second one of the cabinets into its sixth tube.

14. The system as set forth in claim 9, wherein each through module includes a perimeter frame spanning the aisle; wherein the perimeter frame is coupled to the respective opposing pair of the cabinets; and wherein the tubes are coupled to the perimeter frame.

15. The system as set forth in claim 14, further comprising a pipe frame coupled above the perimeter frame of each through module; wherein the pipe frame is coupled to a supply pipe and a return pipe; and wherein the pipes are configured to extract heat from the cabinets via the cooling fluid.
